# EUROPEAN PATENT SPECIFICATION

(11) **EP 1 014 425 B1**
(45) Date of publication and mention of the grant of the patent: **13.02.2008**
(21) Application number: 99125447.5
(22) Date of filing: 20.12.1999
(51) Int. Cl.: H01L 21/00, H01L 21/321

(54) **Mechanism and method for supporting substrate to be coated with film**
Mechanismus und Verfahren zum Halten eines mit einer Schicht zu bedeckenden Substrates
Mécanisme et méthode de support d'un substrat devant être recouvert par une couche

(30) Priority: 22.12.1998 JP 36531098
(43) Date of publication of application: 28.06.2000
(73) Proprietor: Sharp Kabushiki Kaisha, Osaka 545 (JP)
(72) Inventor: Kawaguchi, Masao, Taki-gun, Mie (JP)
(74) Representative: Müller - Hoffmann & Partner

(56) References cited:
- EP-A- 0 865 073
- PATENT ABSTRACTS OF JAPAN vol. 1996, no. 08, 30 August 1996 (1996-08-30) & JP 08 107076 A (SONY CORP), 23 April 1996 (1996-04-23) & JP 08 107076 A (SONY CORP) 23 April 1996 (1996-04-23)
- PATENT ABSTRACTS OF JAPAN vol. 007, no. 123 (E-178), 27 May 1983 (1983-05-27) & JP 58 040837 A (TOUKIYOU OUKA KOGYO KK), 9 March 1983 (1983-03-09)

## Description

### BACKGROUND OF THE INVENTION

### 1. Field of the Invention

The present invention relates to a mechanism and method for supporting a substrate to be coated with a film, for use in liquid crystal display devices and semiconductor devices such as transistors.

### 2. Description of the Related Art

In Japanese Unexamined Patent Publication JP-A 8-107076 (1996), there is described a CVD (Chemical Vapor Deposition) apparatus for forming a thin film on a surface of a supported wafer. In this CVD apparatus, a susceptor is used as a wafer support mechanism. A wafer is placed on a top of the bearing surface of the susceptor which is horizontally held. When the wafer has been placed, the susceptor is angularly displaced so that the bearing surface is vertical. In this state, a thin film is formed on a top of the wafer. Wafer chuck pins are fixed to the bearing surface. The wafer chuck pins support the wafer on the bearing surface and prevent the wafer from falling due to the angular displacement of the susceptor. After the film has been formed, the susceptor is angularly displaced again so that the bearing surface is horizontal. In this state, the wafer is lifted up and transported away.

In the CVD apparatus disclosed in JP-A 8-107076, because the wafer is in contact with the wafer chuck pins when the thin film is formed, thin film material may adhere to surfaces of the wafer chuck pins as well as forming the thin film on the wafer. When the wafer in this state is forcibly lifted up from the top of the susceptor to be transported out, the thin film on the wafer is pulled by the thin film adhering to the wafer chuck pins and is peeled off. Cracks, chips or the like may also be caused in the wafer itself.

In addition, Patent Abstracts of Japan of document JP-A-58-40837 disclose a clamping device in which a semiconductor wafer is supported by a mount plate for processing. Claws are arranged under the stage that protrude therefrom and are slanted when the mount plate is raised so as to securely hold the wafer during processing thereof.

### SUMMARY OF THE INVENTION

An object of the present invention is to provide a mechanism and a method for supporting a substrate to be coated with a thin film, which mechanism and method enable transporting the substrate coated with a thin film out of a film forming apparatus without damaging the thin film as well as the substrate.

According to the present invention, this object is accomplished by a mechanism as defined in claim 1, and by a method as defined in claim 9.

Advantageous further developments of the invention are subject of the accompanying dependent claims.

Summarizing the mechanism claimed, since the support members, which support an end surface of a substrate to be coated with a film, are movable during film formation, peeling-off of the thin film which has been formed on the substrate, as well as cracks and chips in the substrate coated with the thin film can be almost completely prevented by moving the support members before transporting the substrate out of the film forming apparatus after formation of the film.

According to a preferred embodiment, since the support members are moved in parallel, peeling-off of the thin film formed on the substrate, as well as cracks and chips in the substrate can be almost completely prevented by moving the support members before transporting the substrate out of the film forming apparatus after formation of the film.

According to a preferred embodiment, since the direction of movement of the support members is a direction towards or away from the shaft member, the support members can be prevented from rubbing against the end surface of the substrate on which a film has been formed when the support members are moved. Accordingly, dust caused by rubbing can be prevented from being contained in the thin film, with the result that the quality of the thin film is improved.

According to a preferred embodiment, the plurality of support members can be moved in one operation by a single moving means, which makes the structure of the support mechanism simple.

According to a preferred embodiment, the plurality of support members can be moved independently by the moving means respectively provided for the plurality of support members, so that, for example, the respective support members can move in different manners.

According to a preferred embodiment, the movement of the support members can be achieved by an actuator having a simple structure.

According to a preferred embodiment, since the support members are formed in a columnar shape, the areas of the surfaces of the support members which come into contact with the end surface of the substrate to be coated with a film can be decreased. Accordingly, the thin film which has been formed on the substrate tends not to adhere to the support members and peeling-off of the thin film from the substrate, as well as cracks and chips in the substrate can be almost completely prevented.

According to a preferred embodiment, when a thin film is formed on a glass substrate or a semiconductor wafer, peeling-off of the thin film which has been formed on the glass substrate or the semiconductor wafer, as well as cracks and chips in the glass substrate or the semiconductor wafer can be almost completely prevented.

Summarizing the method claimed, since the support members are moved before transporting the substrate out of the film formation apparatus after the completion of film formation on the substrate, peeling-off of the thin film formed on the substrate, as well as cracks and chips in the substrate can be almost completely prevented.

According to a preferred embodiment, because the support members are moved in a direction parallel to one side of the stage, peeling-off of the thin film formed on the substrate, as well as cracks and chips in the substrate can be almost completely prevented.

According to a preferred embodiment, since the direction of movement of the support members is a direction towards or away from the shaft member, the support members can be prevented from rubbing against the end surface of the substrate on which a film has been formed, when the support members are moved. Accordingly, dusts caused by rubbing can be prevented from being contained in the thin film, thereby enabling the quality of the thin film to be improved.

According to a preferred embodiment, when the thin film is formed on a glass substrate or a semiconductor wafer, peeling-off of the thin film which has been formed on the glass substrate or the semiconductor wafer, as well as cracks and chips in the glass substrate or the semiconductor wafer can be almost completely prevented.

### BRIEF DESCRIPTION OF THE DRAWINGS

Other and further objects, features, and advantages of the invention will be more explicit from the following detailed description taken with reference to the drawings wherein:
Fig. 1 is a view showing a film forming apparatus 10;
Fig. 2 is a perspective view showing a support mechanism 20 of the film forming apparatus 10; and
Fig. 3 is a side view showing the support mechanism 20 of the film forming apparatus 10.

### DETAILED DESCRIPTION OF THE PREFERRED EMBODIMENTS

Now referring to the drawings, preferred embodiments of the invention are described below.

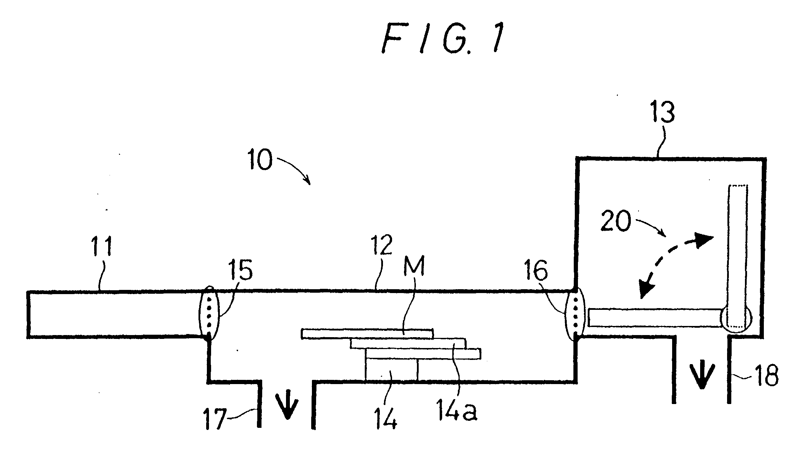

Fig. 1 is a view showing a film forming apparatus 10. The film forming apparatus 10 comprises a load lock chamber 11 which can be sealed, a transport chamber 12, and a film forming chamber 13. The load lock chamber 11 is a passage through which a substrate M to be coated with a film is transported into the film forming apparatus. The transport chamber 12 is connected to the load lock chamber 11 and has a vacuum robot 14 for transporting the substrate M in a vacuum. The film forming chamber 13 is connected to the transport chamber 12 and has a support mechanism 20 for supporting the substrate M.

A gate valve 15 is provided between the load lock chamber 11 and the transport chamber 12, and a gate valve 16 is provided between the transport chamber 12 and the film forming chamber 13. Exhaust pipes 17 and 18 are respectively provided in the transport chamber 12 and film forming chamber 13.

In the film forming apparatus 10, firstly, a substrate M is fed into the interior of the load lock chamber 11 from one end thereof. The load lock chamber 11, the transport chamber 12, and the film forming chamber 13 are then sealed. The gate valves 15 and 16 are then closed and gas inside is exhausted via the exhaust pipes 17 and 18. A vacuum is thus created inside the transport chamber 12 and the film forming chamber 13.

When the substrate M inside the load lock chamber 11 is transported to the gate valve 15, the gate valve 15 opens. The vacuum robot 14 in the transport chamber 12 extends an arm 14a and receives the substrate M to transport the substrate M to the gate valve 16. When the vacuum robot 14 receives the substrate M, the gate valve 15 is closed. When the substrate M has been transported up to the gate valve 16, after the substrate M waits for the transport chamber 12 to be placed in a vacuum state once more through the exhaust of gas from the exhaust pipe 17, the gate valve 16 is opened, and the vacuum robot 14 again extends an arm and transfers the substrate M onto the support mechanism 20 inside the film forming chamber 13. When the substrate M has been transferred, the gate valve 16 is closed.

After film formation has been completed inside the film forming chamber 13, the substrate M is fed back in reverse along the transporting path and is taken out from the load lock chamber 11.

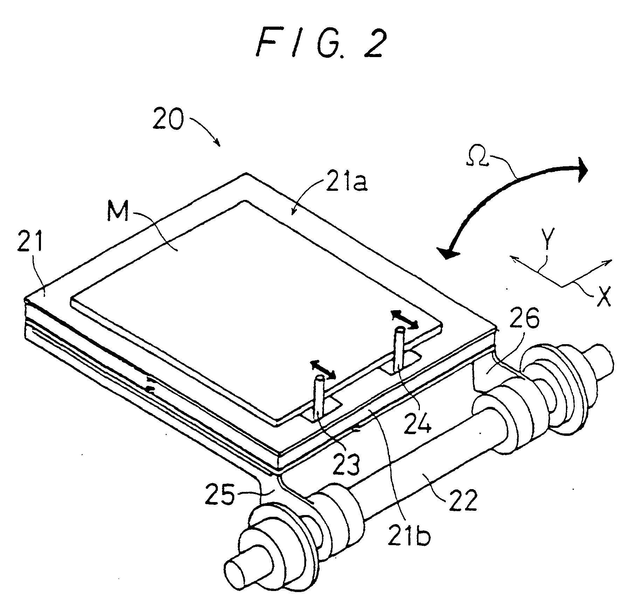

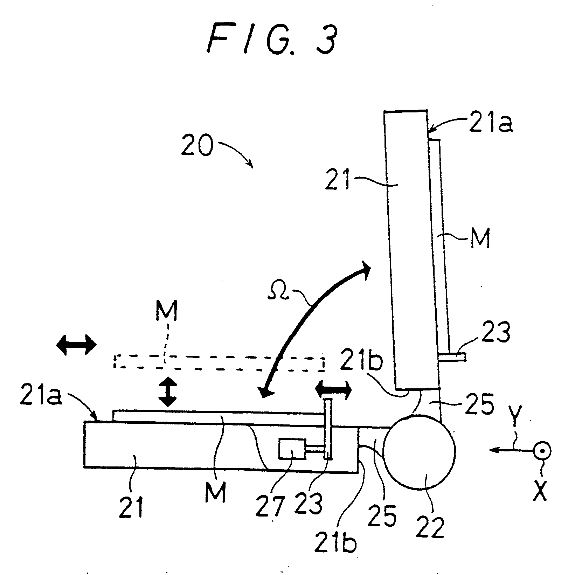

Fig. 2 is a perspective view showing the support mechanism 20 of the film forming apparatus 10 and Fig. 3 is a side view of the same. The support mechanism 20 has a stage 21, a shaft member 22, support pins 23, 24 and the like. The stage 21 is constituted with a rectangular plate-shaped member and has a flat substrate bearing surface 21a on which the substrate M is placed. Directions parallel to two adjacent sides of the stage 21 are taken as direction X and direction Y.

The shaft member 22 is disposed at a predetermined distance from the stage 21 facing an end surface 21b of the stage 21 and extends in the direction X. The stage 21 and the shaft member 22 are linked by link members 25 and 26. The shaft member 22 is rotatable in directions Q about a longitudinal axis thereof. After the substrate M on which film formation has been completed has been transported out by the vacuum robot 14 and while the receipt of the next substrate M by the vacuum robot 14 is being awaited, the shaft member 22 supports the stage 21 in a horizontal state. A position where the stage 21 is being supported in a horizontal state to receive the substrate is hereafter called a substrate receiving position. When film formation is performed, the shaft member 22 rotates to angularly displace the stage 21 up to a film forming position where the substrate bearing surface 21a becomes parallel with a vertical or substantially vertical direction.

The support pins 23, 24 are provided at an end portion of the substrate bearing surface 21a so as to protrude upright from the substrate bearing surface 21a. The support pins 23, 24 can support the end surface of the substrate M from beneath even when the stage 21 is lifted up to the film forming position by rotation of the shaft member 22. By carrying out film formation in this way with the substrate M which has been supported parallel with a vertical or substantially vertical direction, particles and the like can be prevented from falling onto the formed thin film.

The support pins 23, 24 are each formed in a columnar shape and have a small area of contact with the end surface of the substrate M. Accordingly, the thin film which has been formed on the substrate M tends not to adhere to the support pins 23, 24, and peeling-off of the thin film from the substrate M and cracks or chips in the substrate M can be prevented.

The support pins 23, 24 are also both connected to an actuator 27 and can move in the direction Y, namely in a direction in which the pins 23, 24 they either move towards or away from the shaft member 22. After film formation, the support pins 23, 24, contacting with an end surface of the substrate M can be separated therefrom without damaging the substrate M or the thin film which has been formed thereon. The movement of the support pins 23, 24 may be a movement where they move towards the shaft member 22 in the direction Y, a reciprocating motion where after this towards movement they move away from the shaft member 22, or a cyclic oscillating movement.

Note that the support pins 23, 24 are moved by the actuator 27, but dedicated actuators may be individually provided for the respective support pin 23, 24 so as to move the support pins independently of each other.

Next, a support method for a substrate M using the support mechanism 10 shown in Fig. 2 will be explained. Firstly, the substrate M is transported into the film forming chamber 13 and is placed on the stage 21. Next, the stage 21 is angularly displaced from the substrate receiving position at which the substrate M is placed on the stage 21, to the film forming position at which the substrate bearing surface 21a of the stage 21 becomes vertical or substantially vertical. The end surface of the substrate M is thus supported from beneath by the support pins 23, 24.

After film formation, the stage 21 is angularly displaced from the film forming position back to the substrate receiving position. Once the stage 21 has returned to the substrate receiving position from the film forming position, the actuator 27 is driven so as to move the support pins 23, 24. Finally, the substrate M is lifted up and transported out from the film forming chamber 13.

Note that not only a glass substrate but also a semiconductor wafer may be used as the substrate M in the present embodiment. Moreover, the mechanism and method for supporting a substrate to be coated with a film of the invention may be applied to a film forming apparatus for forming a desired film on a glass substrate or a semiconductor wafer.

The invention may be embodied in other specific forms. The present embodiments are therefore to be considered in all respects as illustrative and not restrictive, the scope of the invention being indicated by the appended claims.

## Claims

1. A film forming apparatus having a mechanism for supporting a substrate to be coated with a film, comprising:
a stage (21) arranged to receive a substrate (M) which has been transported into the film forming apparatus (10) to form a film on the substrate;
a shaft member (22) arranged to angularly displace the stage (21) bearing the substrate (M) from a horizontal substrate receiving position at which the stage (21) received the substrate (M) to a film forming position at which a substrate bearing surface (21a) of the stage is vertical or substantially vertical; and
a plurality of support members (23, 24) provided so as to protrude from the substrate bearing surface (21a) of the stage (21) for supporting an end surface of the substrate (M), which faces downwards when the stage (21) is angularly displaced to the film forming position,
**characterized in that**
moving means (27) are provided for moving the support members (23, 24) away from the substrate before transporting the substrate out of the film forming apparatus after formation of the film; and
said plurality of support members (23, 24) is provided only along said end surface of the substrate (M) which faces downwards so that the substrate (M) is held in the vertical position solely by said plurality of support members (23, 24).

2. The apparatus of claim 1, wherein the moving means (27) is arranged to cause the support members (23, 24) to later-ally move away from the substrate in a direction being parallel to one side of the stage (21) and taken as a direction Y on the stage (21).

3. The apparatus of claim 2, wherein the moving means (27) is arranged to move the support members (23, 24) in said direction towards or away from the shaft member (22).

4. The apparatus of claim 1, wherein the moving means (27) is connected together with a plurality of the support members (23, 24) and moves the plurality of support members (23, 24) in one operation.

5. The apparatus of claim 1, wherein a plurality of the moving means (27) are provided to respectively connect with the plurality of support members (23, 24) to move the plurality of support members (23, 24) independently.

6. The apparatus of claim 1, wherein the moving means (27) is an actuator.

7. The apparatus of claim 1, wherein each of the plurality of support members (23, 24) is formed in a columnar shape.

8. The apparatus of claim 1, wherein the substrate (M) is a glass substrate or a semiconductor wafer.

9. A method for supporting a substrate to be coated with a film, which method is used in a film forming apparatus (10), comprising the steps of:
placing a substrate to be coated with a film (M), which substrate has been transported into the film forming apparatus (10), on a stage (21) being in a substantially horizontal substrate receiving position and provided with a plurality of support members (23, 24) being movable relative to the stage (21) in a direction parallel to a side of the stage and away from the substrate;
angularly displacing the stage (21) on which the substrate (M) is placed, from said substrate receiving position at which the substrate (M) has been received by the stage (21), to a film forming position at which a substrate bearing surface (21a) of the stage (21) is vertical or substantially vertical and at which an end surface of the substrate (M) is supported from thereunder by the support members (23, 24); and
angularly displacing the stage (21) from the film forming position back to the substrate receiving position, after film formation;
wherein
said plurality of support members is provided only along said end surface of the substrate which faces downwards so that the substrate is held in the vertical position solely by said plurality of support members;
further comprising the steps of
moving said plurality of support members (23, 24) after the stage (21) has returned to the substrate receiving position away from the substrate before transporting the substrate out of the film forming apparatus after formation of the film; and
transporting the substrate having been coated with a film (M), out of the stage (21) of the film forming apparatus (10), after the movement of the support members (23, 24) away from the coated substrate (M).

10. The method for supporting a substrate to be coated with a film of claim 9, wherein in the step of moving the support members, the support members (23, 24) are laterally moved away from the substrate in a direction being parallel to one side of the stage (21) and taken as a direction Y on the stage (21).

11. The method for supporting a substrate to be coated with a film of claim 10, wherein in the step of moving the support members, the support members (23, 24) are moved in said direction towards or away from a shaft member (22) for angularly displacing the stage (21).

12. The method for supporting a substrate (M) to be coated with a film of claim 9, wherein the substrate (M) is a glass substrate or a semiconductor wafer.

## Patentansprüche

1. Schichterzeugungsvorrichtung mit einem Mechanismus zum Halten eines mit einer Schicht zu bedeckenden Substrats, umfassend:
eine Plattform (21), die zum Aufnehmen eines Substrats (M) angeordnet ist, welches in die Schichterzeugungsvorrichtung (10) transportiert wurde, um eine Schicht auf dem Substrat zu erzeugen;
ein Achsenelement (22), das zum winkeligen Verfahren der das Substrat (M) tragenden Plattform (21) aus einer horizontalen Substrataufnahmeposition, in welcher die Plattform (21) das Substrat (M) empfangen hat, in eine Schichterzeugungsposition, in welcher eine substrattragende Oberfläche (21a) der Plattform vertikal oder im Wesentlichen vertikal ist, angeordnet ist; und
eine Vielzahl von Halteelementen (23, 24), die so bereitgestellt sind, dass sie aus der substrattragenden Oberfläche (21) der Plattform (21) herausragen, zum Halten einer Endoberfläche des Substrats (M), welche nach unten weist, wenn die Plattform (21) winkelig in die Schichterzeugungsposition verfahren ist,
**dadurch gekennzeichnet, dass**
eine Bewegungsmittel (27) bereitgestellt sind zum Bewegen der Halteelemente (23, 24) weg von dem Substrat, bevor das Substrat nach der Schichterzeugung aus der Schichterzeugungsvorrichtung heraustransportiert wird; und
die Vielzahl von Halteelementen (23, 24) nur entlang der Endoberfläche des Substrats (M), welche nach unten weist, bereitgestellt sind, so dass das Substrat (M) nur durch die Vielzahl von Halteelementen (23, 24) in der vertikalen Position gehalten wird.

2. Vorrichtung nach Anspruch 1, bei der die Bewegungsmittel (27) dazu angeordnet sind, die Halteelemente (23, 24) zu veranlassen, sich lateral weg von dem Substrat in einer Richtung zu bewegen, die parallel zu einer Seite der Plattform (21) ist und als eine Richtung Y auf der Plattform (21) bezeichnet wird.

3. Vorrichtung nach Anspruch 2, bei der die Bewegungsmittel (27) dazu angeordnet sind, die Halteelemente (23, 24) in der Richtung hin zu oder weg von dem Achsenelement (22) zu bewegen.

4. Vorrichtung nach Anspruch 1, bei der die Bewegungsmittel (27) mit einer Vielzahl der Halteelemente (23, 24) zusammen verbunden ist und die Vielzahl der Halteelemente (23, 24) in einem Betriebsablauf bewegt.

5. Vorrichtung nach Anspruch 1, bei der eine Vielzahl der Bewegungsmittel (27) bereitgestellt ist, um jeweils mit der Vielzahl von Halteelementen (24, 23) zu verbinden, um die Vielzahl von Halteelementen (23, 24) unabhängig zu bewegen.

6. Vorrichtung nach Anspruch 1, bei der die Bewegungsmittel (27) ein Stellantrieb sind.

7. Vorrichtung nach Anspruch 1, bei der jedes der Vielzahl von Halteelementen (23, 24) in einer Säulenform ausgebildet ist.

8. Vorrichtung nach Anspruch 1, bei der das Substrat (M) ein Glassubstrat oder ein Halbleiterwafer ist.

9. Verfahren zum Halten eines mit einer Schicht zu bedeckenden Substrats, welches Verfahren in einer Schichterzeugungsvorrichtung (10) verwendet wird, umfassend die Schritte:
Platzieren eines mit einer Schicht zu bedeckenden Substrats (M), welches Substrat in die Schichterzeugungsvorrichtung (10) transportiert wurde, auf einer Plattform (21), die sich in einer im Wesentlichen horizontalen Substrataufnahmeposition befindet, und mit einer Vielzahl von Halteelementen (23, 24) versehen ist, die relativ zu der Plattform (21) in einer Richtung parallel zu einer Seite der Plattform und weg von dem Substrat beweglich sind;
winkeliges Verfahren der Plattform (21), auf welchem das Substrat (M) platziert ist, aus der Substrataufnahmeposition, in welcher das Substrat (M) durch die Plattform aufgenommen wurde, in eine Schichterzeugungsposition, in welcher eine substrattragende Oberfläche (21a) der Plattform (21) vertikal oder im Wesentlichen vertikal ist und in welcher eine Endoberfläche des Substrats (M) von unten durch die Halteelemente (23, 24) gehalten wird; und
winkeliges Verfahren der Plattform (21) aus der Schichterzeugungsposition zurück zu der Substrataufnahmeposition nach der Schichterzeugung;
wobei die die Vielzahl von Halteelementen nur entlang der Endoberfläche des Substrats, welche nach unten weist, bereitgestellt ist, so dass das Substrat nur durch die Vielzahl von Halteelementen in der vertikalen Position gehalten wird;
ferner umfassend die Schritte:
Bewegen der Vielzahl von Halteelementen (23, 24), nachdem die Plattform (21) in die Substrataufnahmeposition zurückgekehrt ist, weg von dem Substrat, bevor das Substrat nach der Schichterzeugung aus der Schichterzeugungsvorrichtung transportiert wird; und
Transportieren des Substrats (M), das mit einer Schicht bedeckt wurde, weg von der Plattform (21) der Schichterzeugungsvorrichtung (10), nach der Bewegung der Halteelemente (23, 24) weg von dem bedeckten Substrat (M).

10. Verfahren zum Halten eines mit einer Schicht zu bedeckenden Substrats nach Anspruch 9, bei dem in dem Schritt des Bewegens der Halteelemente die Halteelemente (23, 24) lateral weg von dem Substrat in einer Richtung bewegt werden, die parallel zu einer Seite der Plattform (21) ist und als eine Richtung Y auf der Plattform (21) bezeichnet wird.

11. Verfahren zum Halten eines mit einer Schicht zu bedeckenden Substrats nach Anspruch 10, bei dem in dem Schritt des Bewegens der Halteelemente die Halteelemente (23, 24) in der Richtung hin zu oder weg von einem Achsenelement (22) zum winkeligen Verfahren der Plattform (21) bewegt werden.

12. Verfahren zum Halten eines mit einer Schicht zu bedeckenden Substrats (M) nach Anspruch 9, bei dem das Substrat (M) ein Glassubstrat oder ein Halbleiterwafer ist.

## Revendications

1. Appareil de formation de film comportant un mécanisme pour supporter un substrat destiné à être revêtu d'un film, comprenant:
un plateau (21) conçu pour recevoir un substrat (M) qui a été transféré dans l'appareil de formation de film (10) pour former un film sur le substrat;
un organe formant arbre (22) conçu pour déplacer angulairement le plateau (21) portant le substrat (M) d'une position de réception de substrat horizontale au niveau de laquelle le plateau (21) a reçu le substrat (M) dans une position de formation de film au niveau de laquelle une surface porteuse de substrat (21a) du plateau est verticale ou sensiblement verticale; et
de multiples organes de support (23, 24) disposés de manière à faire saillie sur la surface porteuse de substrat (21a) du plateau (21) pour supporter une surface d'extrémité du substrat (M) qui est tournée vers le bas lorsque le plateau (21) est déplacé angulairement dans la position de formation de film,
**caractérisé en ce que**
des moyens de déplacement (27) sont prévus pour déplacer les organes de support (23, 24) à distance du substrat avant le transfert du substrat hors de l'appareil de formation de film après la formation du film; et
lesdits multiples organes de support (23, 24) sont disposés uniquement le long de ladite surface d'extrémité du substrat (M) qui est tournée vers le bas, afin que le substrat (M) soit maintenu dans la position verticale uniquement par lesdits multiples organes de support (23, 24).

2. Appareil selon la revendication 1, dans lequel les moyens de déplacement (27) sont conçus pour amener les organes de support (23, 24) à se déplacer latéralement à distance du substrat dans une direction parallèle à l'un des côtés du plateau (21) et considérée comme une direction Y sur le plateau (21).

3. Appareil selon la revendication 2, dans lequel les moyens de déplacement (27) sont conçus pour déplacer les organes de support (23, 24) dans ladite direction vers l'organe formant arbre (22) ou à distance de celui-ci.

4. Appareil selon la revendication 1, dans lequel les moyens de déplacement (27) sont reliés à plusieurs des organes de support (23, 24) en même temps et déplacent les multiples organes de support (23, 24) en une seule opération.

5. Appareil selon la revendication 1, dans lequel plusieurs des moyens de déplacement (27) sont conçus pour être respectivement reliés aux multiples organes de support (23, 24), afin de déplacer les multiples organes de support (23, 24) de manière indépendante.

6. Appareil selon la revendication 1, dans lequel les moyens de déplacement (27) consistent en un actionneur.

7. Appareil selon la revendication 1, dans lequel chacun des multiples organes de support (23, 24) est réalisée sous la forme d'une colonne.

8. Appareil selon la revendication 1, dans lequel le substrat (M) est un substrat en verre ou une plaquette de semi-conducteur.

9. Procédé pour supporter un substrat destiné à être revêtu d'un film, lequel procédé est utilisé dans un appareil de formation de film (10) et comprend les étapes qui consistent à:
placer un substrat destiné à être revêtu d'un film (M), substrat qui a été transféré dans l'appareil de formation de film (10), sur un plateau (21) situé dans une position de réception de substrat sensiblement horizontale et muni de multiples organes de support (23, 24) mobiles par rapport au plateau (21) dans une direction parallèle à un côté du plateau et à distance du substrat;
déplacer angulairement le plateau (21) sur lequel le substrat (M) est placé, de ladite position de réception de substrat au niveau de laquelle le substrat (M) a été reçu par le plateau (21), dans une position de formation de film au niveau de laquelle une surface porteuse de substrat (21a) du plateau (21) est verticale ou sensiblement verticale et où une surface d'extrémité du substrat (M) est supportée depuis le dessous par les organes de support (23, 24); et
déplacer angulairement le plateau (21) pour le ramener de la position de formation de film dans la position de réception de substrat, après la formation du film;
lesdits multiples organes de support étant prévus uniquement le long de ladite surface d'extrémité du substrat qui est tournée vers le bas, afin que le substrat soit maintenu dans la position verticale uniquement par lesdits multiples organes de support;
et comprenant également les étapes qui consistent à:
déplacer lesdits multiples organes de support (23, 24) après que le plateau (21) a été ramené dans la position de réception de substrat, à distance du substrat avant de transférer le substrat hors de l'appareil de formation de film après la formation du film; et
transférer le substrat qui a été revêtu d'un film (M) hors du plateau (21) de l'appareil de formation de film (10), après le déplacement des organes de support (23, 24) à distance du substrat (M) revêtu.

10. Procédé pour supporter un substrat destiné à être revêtu d'un film, selon la revendication 9, dans lequel, au cours de l'étape de déplacement des organes de support (23, 24), ces derniers sont déplacés latéralement à distance du substrat dans une direction parallèle à l'un des côtés du plateau (21) et considérée comme une direction Y sur le plateau (21).

11. Procédé pour supporter un substrat destiné à être revêtu d'un film, selon la revendication 10, dans lequel, au cours de l'étape de déplacement des organes de support (23, 24), ces derniers sont déplacés dans ladite direction vers un organe formant arbre (22) ou à distance de celui-ci, pour déplacer le plateau (21) angulairement.

12. Procédé pour supporter un substrat (M) destiné à être revêtu d'un film, selon la revendication 9, dans lequel le substrat (M) est un substrat en verre ou une plaquette de semi-conducteur.
